Europäisches Patentamt

European Patent Office

Office européen des brevets

(19)

(11) Veröffentlichungsnummer : **0 074 550**
**B1**

(12) **EUROPÄISCHE PATENTSCHRIFT**

(45) Veröffentlichungstag der Patentschrift :
**12.02.86**

(21) Anmeldenummer : **82107934.0**

(22) Anmeldetag : **28.08.82**

(51) Int. Cl.⁴ : **F 02 D 1/12**

(54) **Piezo-hydraulischer Steuerblock in Verbindung mit einer Kraftstoffeinspritzanlage.**

(30) Priorität : **08.09.81 DE 3135494**

(43) Veröffentlichungstag der Anmeldung :
**23.03.83 Patentblatt 83/12**

(45) Bekanntmachung des Hinweises auf die Patenterteilung : **12.02.86 Patentblatt 86/07**

(84) Benannte Vertragsstaaten :
**DE FR GB IT**

(56) Entgegenhaltungen :
**DE-A- 2 748 280**
**FR-A- 2 228 944**
**FR-A- 2 264 979**

(73) Patentinhaber : **ROBERT BOSCH GMBH**
**Postfach 50**
**D-7000 Stuttgart 1 (DE)**

(72) Erfinder : **Babitzka, Rudolf**
**Birkenweg 11**
**D-7141 Kirchberg (DE)**
Erfinder : **Beck, Walter**
**Vöhingerweg 3**
**D-7141 Schwieberdingen (DE)**
Erfinder : **Schlagmüller, Walter**
**Frankenstrasse 39**
**D-7141 Schwieberdingen (DE)**

EP 0 074 550 B1

## Beschreibung

### Stand der Technik

Die Erfindung betrifft einen piezohydraulischen Steuerblock nach der Gattung unabhängigen Patentanspruchs. Bekannte Steuerblöcke dieser Art (FR-A-2 264 979) arbeiten mit einem einseitig wirkenden Kolben, bei dem die Gefahr besteht, daß durch einen Führungsspalt Gas in das Druckmedium eingeschleppt wird. Wegen des kleinen Weges des vom piezoelektrischen Treiber bewegten Kolbens müssen federnde Gasblasen im Druckmedium (Dieselöl) aber unbedingt vermieden werden. Ein präzises Arbeiten der Einspritzanlage ist deshalb mit den bekannten einseitig wirkenden Kolben auf die Dauer nicht möglich.

### Vorteile der Erfindung

Die erfindungsgemäße piezohydraulische Steuerblock mit den kennzeichnenden Merkmalen des unabhängigen Patentanspruchs hat demgegenüber den Vorteil, daß das Einschleppen von Gas vermieden und auch das Entstehen von Gasblasen durch aus dem Druckmedium austretendes Gas wirksam unterbunden wird.

Durch die in den abhängigen Patentansprüchen aufgeführten Maßnahmen sind vorteilhafte Weiterbildungen und Verbesserungen des im unabhängigen Patentanspruch angegebenen piezohydraulischen Steuerblocks möglich. Besonders vorteilhaft ist hier die Verbindung der bestehenden Druckräume über Drosselspalte.

### Zeichnung

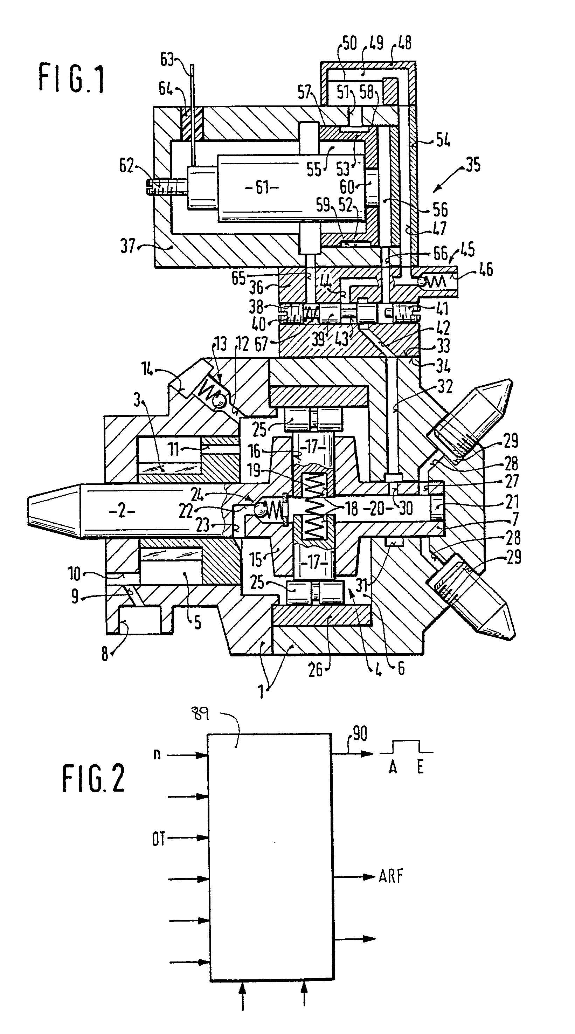

Ein Ausführungsbeispiel des Erfindungsgegenstandes ist in der Zeichnung dargestellt und in der nachfolgenden Beschreibung näher erläutert. Es zeigen Figur 1 einen Längsschnitt durch eine Einspritzanlage mit einem erfindungsgemäßen piezo-hydraulischen Steuerblock und Figur 2 eine schematische Darstellung der Schnittstellen eines elektronischen Steuergerätes mit Eingängen zu verschiedenen Parametern und Ausgängen für Steuerimpulse, u. a. für die Steuerung des Piezostellers.

### Beschreibung des Ausführungsbeispiels

Im Ausführungsbeispiel gemäß Fig. 1 ist in einem zweiteiligen Gehäuse 1 eine Welle 2 gelagert. Außerdem nimmt das Gehäuse 1 eine mit der Welle 2 verbundene Flügelzellenpumpe 3 und eine ebenfalls mit der Welle 2 verbundene Doppelkolbenpumpe 4 in entsprechenden Räumen 5 und 6 auf. Das doppelkolbenpumpenseitige Ende der Welle 2 ist als Verteiler 7 ausgebildet. Das Gehäuse 1 besitzt weiter einen Anschluß 8 für eine Kraftstoffzuleitung, von dem aus Kanäle 9 und 10 zum Raum 5 der Flügelzellenpumpe 3 führen. Ein Kanal 11 verbindet die Druckseite des Raumes 5 mit dem Raum 6. Vom Raum 6 führt ein Kanal 12 über ein Druckbegrenzungsventil 13 zu einem Anschluß 14 für eine Kraftstoffrücklaufleitung. Im Raum 6 ist ein Flansch 15 der Welle 2 angeordnet, der eine in Durchmesserrichtung dieses Flansches verlaufende zylindrische Bohrung 16 aufweist. In dieser zylindrischen Bohrung 16 ist ein Kolbenpaar 17 verschiebbar gelagert. Die Kolben dieses Kolbenpaares 17 besitzen in ihren einander zugewendeten Böden Bohrungen 18, in die eine Schraubendruckfeder 19 unter Vorspannung eingebracht ist. Eine Längsbohrung 20 in der Welle 2 ist stirnseitig durch einen Stopfen 21 abgedichtet. Sie setzt sich quer durch die Bohrung 16 zum antriebsseitigen Ende der Welle 2 hin fort, bis sie über einen Konus in eine Axialbohrung 22 übergeht. Diese Axialbohrung 22 ist mittels einer Radialbohrung 23 mit dem Raum 6 verbunden. In dem Übergangskonus von der Längsbohrung 20 zur Axialbohrung 22 ist die Kugel eines Rückschlagventils 24 eingepaßt. Jeder Kolben des Kolbenpaares 17 stützt sich außen gegen ein Rollenpaar 25 ab.

Die Rollenpaare 25 werden damit gegen die innere, kurvenförmige Fläche eines Kurvenringes 26 gepreßt. Kurz vor dem Stopfen 21 besitzt die Welle 2 eine Radialbohrung 27. Diese Radialbohrung 27 kann je nach Drehstellung der Welle 2 mit einem von mehreren stirnförmig um die Welle herum angeordneten Kanälen 28 fluchten. Die Kanäle 28 führen über Anschlußstellen 29 zu den Einspritzdüsen. Eine weitere Radialbohrung 30 in der Welle 2 führt in eine Ringnut 31 in der das Verteilerende 7 der Welle 2 aufnehmenden Bohrung im Gehäuse 1. Von dieser Ringnut 31 führt ein Kanal 32 zu einer Anschlußfläche 33 am Gehäuse 1. An diese Anschlußfläche ist die Anschlußfläche 34 eines piezo-hydraulischen Steuerblocks 35 angepreßt. Der piezo-hydraulische Steuerblock besteht aus einem Schiebergehäuse 36 und einem Treibergehäuse 37 mit in ihnen enthaltenen Treiber- und Steuerelementen. In einer Bohrung 38 im Schiebergehäuse 36 ist ein Steuerschieber 39 gelagert. Seine Länge ist so bemessen, daß er zwischen zwei die Enden der Bohrung 38 nach außen verschließenden Gewindebolzen 40 und 41 einen einstellbaren Schieberweg hat. Bei aufeinandergepaßten Anschlußflächen 33 und 34 fluchtet ein Kanal 42 im Schiebergehäuse 36 mit dem Kanal 32 im Gehäuse 1. Der Kanal 42 führt zur Bohrung 38. Dort wo der Kanal 42 auf die Bohrung 38 trifft, besitzt der Steuerschieber 39 eine Eindrehung 43, deren eine Begrenzungskante die Kanalöffnung zur Bohrung 38 entweder freigeben oder verschließen kann. Die Länge der Eindrehung 43 ist so bemessen, daß durch sie stets auch eine Einlaßöffnung eines Kanals 44· freigegeben wird, der ebenfalls im Schiebergehäuse 36 verläuft und über ein Entlastungsventil 45 in einem Anschluß 46 für eine Rücklaufleitung mündet. Vor dem Entlastungsventil 45 ist vom Kanal 44 ein weiterer Kanal 47 abgezweigt, der teilweise im Schiebergehäuse 35, zum größeren Teil im Deckel des Treibergehäuses 37 und schließlich in einem Aufsatz 48 zum Treibergehäuse 37 verläuft. Im Aufsatz 48 mündet der Kanal 47 in einem Raum 49. Der Raum 49 kann durch eine Membran 50 unterteilt sein, muß es aber nicht. Eine Wand des Raumes 49 wird durch das Treibergehäuse 37 gebildet. In dieser Wand endet ein Kanal 51 der andererseits in einem zylindrischen Raum 52 mündet. Der Raum 52 nimmt einen Kolben 53 auf und ist durch einen Deckel 54 nach außen hin verschlossen. Der Kolben 53 teilt den Raum 52 in zwei getrennte Druckräume 55 und 56 auf. Dabei bildet er Drosselspalte 57 und 58, durch die die Druckräume 55 und 56 mit dem Druckanschluß über den Kanal 51 verbunden sind. Eine Eindrehung 59 im Mantel des Kolbens 53 trennt die beiden Drosselspalte 57 und 58 klar. Der Kolben 53 ist weiter durch einen Zapfen 60 fest verbunden mit einem Treiber 61 aus Piezokeramik. Dieser Treiber 61 ist als Säule aufgebaut und über einen Gewindezapfen 62 mit dem Treibergehäuse 37 verbunden. Der elektrische Anschluß des Treibers 61 erfolgt über ein Kabel 63, das durch eine Dichtung 64 nach außen geführt ist. Die Druckräume 55 und 56 sind schließlich über Kanäle 65 und 66, die teilweise im Treibergehäuse 37, teilweise im Schiebergehäuse 36 verlaufen, mit den Freiräumen beiderseits des Steuerschiebers 39 in der Bohrung 38 verbunden.

Bei inganggesetzter Kraftststoffeinspritzanlage wird die Welle 2 gedreht. Die damit angetriebene Flügelzellenpumpe 3 saugt Kraftstoff vom Anschluß 8 her an und preßt ihn druckseitig aus dem Raum 5 durch den Kanal 11 zum Raum 6. Vom so mit Kraftstoff angefüllten Raum 6 wird der Kraftstoff durch die Doppelkolbenpumpe 4 über das Kugelventil 24 angesaugt und von dem Kolbenpaar 17 in die Längsbohrung 20 des Verteilers 7 gedrückt. Von dort durch die Radialbohrung 27 und einen der Kanäle 28 zu einer Einspritzdüse und über die Radialbohrung 30 und durch die Kanäle 32 und 42 zum Steuerschieber 39. Ist die Mündung des Kanals 42 durch den Steuerschieber 39 freigegeben, wird durch die Kanäle 44 und 47 und begrenzt durch das Entlastungsventil 45 Flüssigkeitsdruck auch im Raum 49 aufgebaut. Überflüssiger Kraftstoff fließt bei steigendem Druck am Anschluß 46 ab. Der Flüssigkeitsdruck wirkt über die Membran auf die Hydraulikflüssigkeit im Treibergehäuse 37. Jeder freie Raum innerhalb des Treibergehäuses 37 und des Aufsatzes 48 sowie in den Kanälen 65 und 66 und beiderseits des Steuerschiebers 39 ist mit Hydraulikflüssigkeit blasenfrei gefüllt. Wird der Treiber 61 an Spannung gelegt, dehnt er sich aus und treibt dabei den Kolben 53 in der Darstellung nach Fig. 1 nach rechts. Damit wird schlagartig der Druck im Druckraum 56 gesteigert und der Druck im Druckraum 55 abgesenkt. Durch die entstehende Druckdifferenz wird der Steuerschieber 39 nach links getrieben und die Mündung des Kanals 42 in die Bohrung 38 verschlossen. Sofort baut sich in der Doppelkolbenpumpe und im Verteiler 7 der Einspritzdruck auf und treibt, je nach Stellung des Verteilers 7 Kraftstoff durch die gerade ausgewählte Einspritzdüse. Wird die elektrische Spannung abgeschaltet, wechseln die Druckverhältnisse in den Druckräumen 55 und 56. Der Druck im Druckraum 55 steigt, der Druck im Druckraum 56 fällt. Damit wird der Steuerschieber 39 aus der in Fig. 1 gezeigten Schließstellung nach rechts in seine Offenstellung bewegt. Mittels des Gewindebolzens 41 ist diese Stellung einstellbar. Ebenso kann die Schließstellung durch Drehen des Gewindebolzens 40 eingestellt werden. Der Einspritzvorgang ist beendet.

Von der Flügelzellenpumpe geförderter aber von der Doppelkolbenpumpe 4 nicht aufgenommener Kraftstoff fließt über das Entlastungsventil 13 zurück zum Kraftstoffbehälter.

Bei der Umsetzung des kleinen Weges des durch den Treiber 61 bewegten Kolbens 53 in einen nutzbaren Weg des Steuerschiebers 39 ist es wichtig, daß im Druckmedium (Dieselöl) keine Gasblasen vorhanden sind. Dies wird dadurch erreicht, daß beim Füllen des Treibergehäuses und des Schiebergehäuses das Öl entgast wird und im Betrieb die Druckräume 55 und 56 durch den im Raum 49 anliegenden Druck ständig hydraulisch vorgespannt sind. Beim hier vorliegenden doppelseitig wirkenden Kolben 53 besteht im Gegensatz zu einem einseitig wirkenden Kolben nicht die Gefahr, daß durch einen Führungsspalt Gas in das Druckmedium eingeschleppt wird. Außerdem erfolgt das Betätigen des Steuerkolbens stets durch Verdichten des Druckmediums im entsprechenden Druckraum, so daß keine störenden Blasen durch aus der Lösung austretendes Gas entstehen können. Ein besonderes Problem bei der direkten Umsetzung des kleinen durch den Treiber 61 bewirkten Kolbenwegs für Steuerzwecke ist die Längenänderung des Treibers 61 als Folge von Temperaturschwankungen. Bei der hier vorgenommenen hydraulischen Übersetzung kommt noch die unterschiedliche Volumenausdehnung des Druckmediums und des Treibergehäuses 37 hinzu. Um diese Effekte zu kompensieren, sind folgende Maßnahmen getroffen :

1. Der Weg des Steuerschiebers 39 ist durch einstellbare mechanische Anschläge begrenzt.

2. Die Druckräume 55 und 56 sind durch Drosselspalte 57 und 58 miteinander verbunden.

3. Die Druckräume 55 und 56 sind durch Drosselspalte 57 und 58 mit dem Druckraum 49 verbunden.

4. Das hydraulische Übersetzungsverhältnis Kolbenquerschnitt zu Steuerschieberquerschnitt ist größer als das Verhältnis Steuerschieberweg zu Kolbenweg.

5. Der Steuerschieber 39 ist durch eine Druckfeder 67 in Richtung zu seiner den Durchfluß in der getrennten Flüssigkeitsleitung 30, 32, 42, 38, 44, 45, 46 offenlassenden Ruhelage vorgespannt.

6. Der Längenausdehnungskoeffizient des Kolbens 53 ist größer als der des Treibergehäuses 37.

Das gesteuerte Anlegen von Spannung an den piezo-elektrischen Steller kann vorzugsweise mit einem an sich bekannten Steuergerät 89 erfolgen, wie es mit seinen Schnittstellen schematisch in Figur 2 gezeigt ist. Als zu berücksichtigende Parameter sind Eingänge mit Signalen für die Motordrehzahl, die Last, die Lage des oberen Totpunkts für Zylinder 1, die Temperatur von Öl, Wasser und Luft, die Kraftstoffsorte und den Luftdruck oder Ladedruck vorgesehen. Der erste Ausgang 90 dient der Abgabe des Signals zum Ein- (E) und Ausschalten (A) der Steuerspannung für den piezoelektrischen Steller. Weitere Ausgänge am Steuergerät 89 können beispielsweise die Abgasrückführung (ARF) oder die Notabschaltung des Motors steuern.

**Patentansprüche**

1. Piezo-hydraulischer Steuerblock (35) für eine Verteilereinspritzpumpe (3, 4, 7) eines Verbrennungsmotors, vorzugsweise Dieselmotors, mit einem piezo-elektrisch wirkenden Treiber (61), der mit einem Kolben (53) verbunden ist, der, unter der Wirkung des Treibers (61), einen mit Flüssigkeit gefüllten Druckraum zwischen sich und einem als Fördermengenstellglied für die Einspritzpumpe (3, 4, 7) wirkenden Steuerschieber (39) verschieben kann ; wobei der Steuerschieber (39) einen wesentlich kleineren Querschnitt hat als der Kolben (53), in einem mit der Druckseite der Einspritzpumpe (3, 4, 7) verbundenen Steuerzylinder (38) beweglich geführt ist, diesen Steuerzylinder (38) in zwei Räume teilt und in seinem mittleren Teil einen verringerten Querschnitt aufweist, der in mindestens einer seiner möglichen Stellungen eine Druckentlastungsleitung (30, 32, 42, 38, 44, 45, 46) für die Druckseite der Einspritzpumpe (3, 4, 7) offenläßt und in mindestens einer anderen Stellung diese Leitung schließt, dadurch gekennzeichnet, daß der Kolben (53) in einem mit entgaster Flüssigkeit gefüllten Raum geführt ist, den er in zwei mit dieser Flüssigkeit gefüllte, durch Anschluß (47, 49) an die Druckseite der Einspritzpumpe (3, 4, 7) ständig hydraulisch vorgespannte Druckräume (55, 56) trennt, die ihrerseits mit den zwei im Steuerzylinder (38) beiderseits des Steuerschiebers (39) liegenden Druckräumen über getrennte Kanäle (65, 66) verbunden sind.

2. Piezo-hydraulischer Steuerblock nach Anspruch 1, dadurch gekennzeichnet, daß die durch den Steuerschieber (39) verschließbare oder freigebbare Flüssigkeitsleitung die Druckentlastungsleitung des Verteilers (7) der Einspritzpumpe (4) ist.

3. Piezo-hydraulischer Steuerblock nach einem der Ansprüche 1 und 2, dadurch gekennzeichnet, daß der Steuerzylinder (38) beiderseits des Steuerschiebers (39) durch einstellbare mechanische Anschläge (40, 41) für den Steuerschieber (39) verschlossen ist.

4. Piezo-hydraulischer Steuerblock nach einem der Ansprüche 1 bis 3, dadurch gekennzeichnet, daß die Druckräume (55, 56) beiderseits des Kolbens (53) durch Drosselspalte (57, 58) mit dem Druckanschluß (49, 51) für die Hydraulikflüssigkeit und untereinander verbunden sind.

5. Piezo-hydraulischer Steuerblock nach einem der Ansprüche 1 bis 4, dadurch gekennzeichnet, daß das hydraulische Übersetzungsverhältnis Kolbenquerschnitt zu Steuerschieberquerschnitt größer ist als das Verhältnis Steuerschieberweg zu vom piezo-elektrisch wirkenden Treiber (61) abnehmbaren Weg.

6. Piezo-hydraulischer Steuerblock nach einem der Ansprüche 1 bis 5, dadurch gekennzeichnet, daß der Steuerschieber (39) durch eine Druckfeder (67) in Richtung seiner den Durchfluß in der getrennten Flüssigkeitsleitung (30, 32, 42, 38, 44, 45, 46) offenlassenden Ruhelage vorgespannt ist.

7. Piezo-hydraulischer Steuerblock nach einem der Ansprüche 1 bis 6, dadurch gekennzeichnet, daß der Längenausdehnungskoeffizient des Kolbens (53) größer ist als der des ihn umgebenden Gehäuses (37).

**Claims**

1. Piezo-hydraulic control block (35) for a distributor injection pump (3, 4, 7) of an internal combustion engine, preferably a diesel engine, having a piezo-electrically acting driver (61) which is connected to a piston (53) which, under the action of the driver (61), can displace a pressure chamber, filled with fluid, between itself and a control valve (39) acting as a delivery quantity positioning member for the injection pump (3, 4, 7), the control valve (39) having an essentially smaller cross-section than the piston (53), being movably guided in a control cylinder (38) connected to the pressure side of the injection pump (3, 4, 7), dividing this control cylinder (38) into two chambers and having a reduced cross-section in its centre part, which reduced cross-section, in at least one of its possible positions, leaves open a pressure-relief line (30, 32, 42, 38, 44, 45, 46) for the pressure side of the injection pump (3, 4, 7) and, in at least one other position, closes this line, characterised in that the piston (53) is guided in a chamber which is filled with degassed fluid and which it divides into two pressure chambers (55, 56) which are filled with this fluid, are constantly pre-loaded hydraulically by connection (47, 49) to the pressure side of the injection pump (3, 4, 7) and which, in turn, are connected via separate channels (65, 66) to the two pressure chambers located in the control cylinder (38) on both sides of the control valve (39).

2. Piezo-hydraulic control block according to Claim 1, characterised in that the fluid line which can be closed or released by the control valve (39) is the pressure-relief line of the distributor (7) of the injection pump (4).

3. Piezo-hydraulic control block according to one of Claims 1 and 2, characterised in that the control cylinder (38) is closed on both sides of the control valve (39) by adjustable mechanical stops (40, 41) for the control valve (39).

4. Piezo-hydraulic control block according to one of Claims 1 to 3, characterised in that the pressure chambers (55, 56) on both sides of the pistons (53) are connected to the pressure connection (49, 51) for the hydraulic fluid and to one another by throttle gaps (57, 58).

5. Piezo-hydraulic control block according to one of Claims 1 to 4, characterised in that the hydraulic transmission ratio of piston cross-section to control valve cross-section is greater than the ratio of control valve travel to the travel which can be removed by the piezo-electrically acting driver (61).

6. Piezo-hydraulic control block according to one of Claims 1 to 5, characterised in that the control valve (39) is pre-loaded by a compression spring (67) in the direction of its neutral position which leaves open the through-flow in the separate fluid line (30, 32, 42, 38, 44, 45, 46).

7. Piezo-hydraulic control block according to one of Claims 1 to 6, characterised in that the coefficient of linear expansion of the piston (53) is greater than that of the housing (37) enclosing it.

## Revendications

1. Bloc de contrôle piézo-hydraulique (35) pour une pompe d'injection répartitrice (3, 4, 7) d'un moteur à combustion interne, de préférence un moteur Diesel, avec un excitateur (61) agissant piézo-électriquement et qui est relié à un piston (53) qui sous l'action de l'excitateur (61) peut déplacer une chambre de pression remplie de liquide entre lui et un tiroir de commande (39) agissant comme organe de réglage de la quantité refoulée pour la pompe d'injection (3, 4, 7), cependant que le tiroir de commande (39) a une section transversale notablement plus petite que le piston (53), qu'il est guidé dans un cylindre de commande (38) relié au côté sous pression de la pompe d'injection (3, 4, 7), qu'il utilise ce cylindre de commande (38) en deux chambres, et qu'il comporte dans sa partie médiane une section transversale réduite qui, au moins dans une de ses positions possibles laisse ouverte une canalisation de délestage de pression (30, 32, 43, 38, 44, 45, 46) pour le côté sous pression de la pompe d'injection (3, 4, 7) et qui dans au moins une autre position, ferme cette canalisation, bloc de contrôle caractérisé en ce que le piston (53) est guidé dans une chambre remplie d'un liquide dégazé qu'il sépare en deux chambres de pression (55, 56) remplies par ce liquide, et précontraintes hydrauliquement en permanence par un raccordement (47, 49) au côté sous pression de la pompe d'injection (3, 4, 7), ces chambres sous pression étant de leur côté reliées par l'intermédiaire de canaux séparés (65, 66) aux deux chambres de pression situées dans le cylindre de commande (38) des deux côtés du tiroir de commande (39).

2. Bloc de contrôle piézo-hydraulique selon la revendication 1, caractérisé en ce que la canalisation du liquide susceptible d'être fermée ou bien d'être libérée par le tiroir de commande (39) est la canalisation de délestage en pression du répartiteur (7) de la pompe d'injection (4).

3. Bloc de contrôle piézo-hydraulique selon une des revendications 1 et 2, caractérisé en ce que le cylindre de commande (38) est fermé des deux côtés du tiroir de commande (39) par des butées mécaniques réglables (40, 41) pour le tiroir de commande (39).

4. Bloc de contrôle piézo-hydraulique selon une des revendications 1 à 3, caractérisé en ce que les chambres de pression (55, 56) des deux côtés du piston (53) sont reliées entre elles, ainsi qu'aux raccords sous pression (49, 51) pour le liquide hydraulique, par des fentes d'étranglement (57, 58).

5. Bloc de contrôle piézo-hydraulique selon une des revendications 1 à 4, caractérisé en ce que le rapport de surmultiplication hydraulique entre la section transversale du piston et la section transversale du tiroir de commande, est plus grand que le rapport de la course du tiroir de commande à la course susceptible d'être parcourue par l'excitateur (61) agissant piézo-électriquement.

6. Bloc de contrôle piézo-hydraulique selon une des revendications 1 à 5, caractérisé en ce que le tiroir de commande (39) est précontraint par un ressort de pression (67) en direction de sa position de repos laissant ouvert le passage dans la canalisation séparée (30, 32, 42, 38, 44, 45, 46).

7. Bloc de contrôle piézo-hydraulique selon une des revendications 1 à 6, caractérisé en ce que le coefficient de dilatation longitudinale du piston (53) est supérieur à celui du boîtier (37) qui l'entoure.

FIG.1

FIG.2